# EUROPÄISCHE PATENTSCHRIFT

(11) **EP 1 835 575 B1**
(45) Veröffentlichungstag und Bekanntmachung des Hinweises auf die Patenterteilung: **19.05.2010**
(21) Anmeldenummer: 07090048.5
(22) Anmeldetag: 16.03.2007
(51) Int. Cl.: H01S 5/024, H01S 5/20, H01S 5/227, H01S 5/34

(54) **Quantenkaskadenlaser und Verfahren zu seiner Herstellung**
Quantum cascade laser and method for its production
Laser à cascades quantiques et son procédé de fabrication

(30) Priorität: 17.03.2006 DE 102006013442
(43) Veröffentlichungstag der Anmeldung: 19.09.2007
(73) Patentinhaber: Humboldt-Universität zu Berlin, D-10099 Berlin (DE)
(72) Erfinder: Masselink, William Ted, 12205 Berlin (DE); Semtsiv, Mykhaylo, 12627 Berlin (DE); Dreßler, Sebastian, 93047 Regensburg (DE)
(74) Vertreter: Theobald, Andreas

(56) Entgegenhaltungen:
- EP-A- 1 317 036
- JP-A- 57 136 385
- US-B1- 6 463 088
- OGURA M ET AL: "ALGAAS/GAAS BURIED QUANTUM WELL LASER DIODES BY ONE TIME SELECTIVE METALORGANIC CHEMICAL VAPOR DEPOSITION GROWTH ON DIELECTRIC WINDOW STRIPES" APPLIED PHYSICS LETTERS, AIP, AMERICAN INSTITUTE OF PHYSICS, MELVILLE, NY, US, Bd. 62, Nr. 26, 28. Juni 1993 (1993-06-28), Seiten 3417-3419, XP000382491 ISSN: 0003-6951
- LEE H P ET AL: "CHARACTERISTICS OF DOUBLE-HETEROSTRUCTURE GAAS/ALGAAS LASER DIODES ON SI SUBSTRATES BY SELECTIVE-AREA MOLECULAR-BEAM EPITAXY" JOURNAL OF VACUUM SCIENCE AND TECHNOLOGY: PART B, AVS / AIP, MELVILLE, NEW YORK, NY, US, Bd. 8, Nr. 2, 1. März 1990 (1990-03-01), Seiten 343-348, XP000237960 ISSN: 1071-1023
- FARMER C D ET AL: "A quantum cascade laser fabricated using planar native-oxide layers" APPLIED PHYSICS LETTERS, AIP, AMERICAN INSTITUTE OF PHYSICS, MELVILLE, NY, US, Bd. 77, Nr. 1, 3. Juli 2000 (2000-07-03), Seiten 25-27, XP012026009 ISSN: 0003-6951

## Beschreibung

Die vorliegende Erfindung betrifft einen Halbleiterlaser sowie ein Verfahren zum Herstellen eines Halbleiterlasers.

Ein typischer Halbleiterlaser ist beispielsweise in EP 1 317 036 A2 beschrieben. Auf einem Substrat ist eine aktive Zone vorhanden, an die sich lateral eine Isolationszone anschließt. Die aktive Zone weist einen Schichtstapel auf, der vom Substrat beginnend eine erste Mantelschicht, eine erste Wellenleiterschicht, eine aktive Schicht, eine zweite Wellenleiterschicht und eine zweite Mantelschicht umfasst. Die Photonen der Laserstrahlung werden in der aktiven Schicht gebildet und von den angrenzenden Wellenleiterschichten aus dem Halbleiterlaser herausgeleitet. Das Material der Mantelschichten ist derart gewählt, dass es einen niedrigeren Brechungsindex als die Wellenleiterschichten aufweist, sodass die Wellenleiterschichten zusammen mit den Mantelschichten einen Lichtleiter bilden. Die Isolationszone grenzt lateral an den Schichtstapel an und dient dazu, sowohl den Stromfluss als auch die Lichtausbreitung lateral auf die aktive Zone zu begrenzen.

Während des Betriebs erzeugt ein derartiger Halbleiterlaser Wärme, die zu einer Temperaturerhöhung in der aktiven Zone, also im Schichtstapel des Halbleiterlasers, im Vergleich zur Umgebungstemperatur führt. Eine erhöhte Temperatur der aktiven Zone führt jedoch zu einer Anzahl unerwünschter Effekte, beispielsweise zu einer Erhöhung des Stroms, der zum Generieren einer bestimmten Emissionsintensität des Lasers nötig ist, und zu einer kürzeren Lebensdauer des Lasers.

Insbesondere so genannte Quantenkaskadenlaser, wie sie bspw. in J. Faist et al., Science, Vol. 264, 22. April 1994 oder in DE 10 2004 009 531 A1 beschrieben sind, weisen eine hohe Temperaturempfindlichkeit auf. Gegenüber einem gewöhnlichen Halbleiterlaser ist in einem Quantenkaskadenlaser die aktive Schicht durch eine Schichtfolge so genannter Quantentopfschichten (engl. quantum wells) ersetzt, die jeweils durch Barrierenschichten voneinander getrennt sind. Jeweils eine Anzahl mehrerer aufeinander folgender Quantentöpfe und Barrieren bilden zusammen eine so genannte Kaskade. Jede Kaskade weist eine aktive Schicht auf, in der ein Emissionsprozess stattfindet. Aufgrund der geringen Dicke der Quantentopfschichten können Elektronen in diesen Schichten lediglich bestimmte diskrete Energiewerte aufweisen. In der aktiven Schicht finden Übergänge von einem hohen Energieniveau auf ein niedrigeres Energieniveau, sog. Intersubband-Übergänge, statt, wobei die Differenzenergie in Form von die Laserstrahlung bildenden Photonen abgegeben wird. Das nun ein niedrigeres Energieniveau aufweisende Elektron wird an die nächste Kaskade des Quantenkaskadenlasers weitergegeben, dessen Energieniveaus im Vergleich zu den Energieniveaus der vorausgehenden Kaskade zu niedrigeren Energien hin versetzt sind. In dieser Kaskade kann daher ein weiterer Übergang auf ein noch niedrigeres Energieniveau stattfinden. Typischerweise weisen Quantenkaskadenlaser zwanzig bis hundert solcher Kaskaden auf. Einen Überblick über verschiedene Entwurfsansätze für Quantenkaskadenlaser gibt J. Faist et al., IEEE Journal of Quantum Electronics, Vol. 38, No. 6, Juli 2002.

Bei einer erhöhten Temperatur der Kaskaden kann es jedoch vorkommen, dass Elektronen aus einem hohen Energieniveau einer Kaskade in das untere Energieniveau der vorausgegangenen Kaskade zurückfließen anstatt unter Emission eines Photons auf ein niedriges Energieniveau in der Kaskade übergehen. Zurückfließenden Elektronen besetzen dann das niedrige Energieniveau der vorausgegangenen Kaskade, sodass dort die Rate an Übergängen vom hohen Energieniveau in das niedrige Energieniveau verringert wird. Dies kann zu einer Verringerung der Lasereffizienz führen, insbesondere wenn der Laser kontinuierlich oder mit langen Laserpulsen betrieben wird oder bei Betrieb des Lasers bei Zimmertemperatur.

Es ist daher von Bedeutung, die erzeugte Wärme optimal abzuführen, um die Temperatur in der aktiven Zone, und hier insbesondere in der aktiven Schicht, möglichst niedrig zu halten. Es bestehen daher Bestrebungen, ein Laserdesign zu finden, mit dem Wärme zuverlässig abgeführt werden kann.

In Halbleiterlasern, insbesondere in Quantenkaskadenlasern, ist die aktive Zone ein Streifen mit etwa 10 bis 30 mm Breite. Dieser Streifen legt fest, wo der Stromfluss stattfindet und die Photonen generiert werden. Zudem schränkt er die optischen Moden des Lasers räumlich ein. Der Überlapp der optischen Moden mit der Zone, in der die Photonen generiert werden, ist ein wichtiger Faktor für die Effizienz des Lasers. Das Herstellen eines Halbleiterlasers erfolgt, indem der oben beschriebene Schichtstapel auf dem Streifen gebildet wird und anschließend die Wände des Schichtstapels mit einem isolierenden Material, beispielsweise Benzocyclobuten (BCB) oder, wie in EP 1 317 036 A2, mit polykristallinem oder amorphen Aluminiumgalliumnitrid (AIGaN) isoliert werden.

Wenn BCB als Isolator Verwendung findet, so hat dies den Nachteil, dass dieses Material kein guter Wärmeleiter ist. Dies führt zu der bereits erwähnten Erhöhung der Temperatur in der aktiven Zone, da ein Wärmeabfluss in laterale Bereiche nicht möglich ist. Zwar kann die Wärme vertikal zu einem oberen Goldkontakt bzw. einem unteren Goldkontakt abgeführt werden, jedoch reicht dies nicht aus, um einen Temperaturanstieg in der aktiven Zone ausreichend zu unterdrücken.

Wenn wie in EP 1 317 036 A2 Aluminiumgalliumnitrid als Isolatormaterial Verwendung findet, so lässt sich damit im Vergleich zu BCB als Isolatormaterial die laterale Wärmeabfuhr verbessern. Das Herstellen der polykristallinen oder amorphen Aluminiumgalliumnitridschichten erfolgt dabei mittels selektiver Epitaxie. In dieser hängt es von den in dem Epitaxieverfahren verwendeten Parametern ab, ob der Schichtstapel auf dem Substrat oder das polykristalline bzw. amorphe Aluminiumgalliumnitrid auf einer Siliziumoxidmaske wächst. Das Herstellen des Halbleiterlasers gemäß EP 1 1317 036 A2 erfordert daher ein präzises Justieren der während des Epitaxieverfahrens zur Anwendung kommenden Parameter.

Eine alternative Möglichkeit, die Isolationszone eines Halbleiterlasers herzustellen, ist die Verwendung eines sog Re-Growth-Verfahrens, wie es bspw. in US2005/0186798 A1 beschrieben ist. In einem derartigen Verfahren wird mittels eines ersten Wachstumsprozesses ein Schichtstapel auf ein Substrat aufgebracht und mittels eines Ätzprozesses strukturiert. Bei dieser Strukturierung wird eine Mesa-Struktur herausgebildet, welche in der fertigen Vorrichtung den Halbleiterlaser bildet. Nach dem Herausbilden der Mesa-Struktur erfolgt ein erneutes Aufbringen von Material mittels eines zweiten Wachstumsprozesses (sog. Re-Growth), um die Isolationszone herzustellen.

M. Ogura, et al., "AlGaAS/GaAS buried quantum well diodes by one time selective metalorganic chemical vapor deposition growth on dielectric window stripes", Applied Physics Letters 62 (1993) 28 June, No 26, Woodbury, NY, US beschreiben Laserdioden und Verfahren zu Ihrer Herstellung. Mittels eines metallorganischen Abscheidungsverfahren aus der Dampfphase (MOVCD) wird in diesen Dokumenten die aktive Zone der Laserdiode gleichzeitig mit einer an die aktive Zone lateral angrenzenden elektrischen Isolationszone gebildet. In den Bereichen, in denen die elektrische Isolationszone gebildet werden soll, ist zuvor eine Siliziumoxidfilm gebildet worden, der dazu führt, dass das Material in diesen Bereichen polykristallin wächst, wohingegen es dort, wo die Siliziumoxidschicht nicht vorhanden ist, einkristallin wächst.

Henry P. Lee, et al., "Characteristics of double-heterostructure GaAs/AlGaAs laser diodes on Si substrates by selective-area molecular-beam epitaxy" Journal of Vacuum Science & Technology 8257B, 8 (19) März/April, No. 2, New York , US beschreibt ein Herstellungsverfahren für Laserdioden auf Siliziumsubstraten mittels selektiver Molekularstrahlepitaxie. Auf das Siliziumsubstrat wird dort, wo eine elektrische Isolationszone gebildet werden soll, eine Siliziumnitritschicht aufgebracht. Während des Epitaxieprozesses wächst das abgeschiedene Material auf dieser Nitritschicht polykristallin wohingegen es dort, wo die Siliziumnitritschicht nicht vorhanden ist, einkristallin wächst.

JP 57136385 A beschreibet ein Verfahren zum Herstellen eines Halbleiterlasers, in dem zuerst eine Mesastruktur gebildet wird, anschließend außerhalb der Mesastruktur eine polykristalline Schicht aufgebracht wird, welche dieselbe Dicke wie die Mesastruktur besitzt, und schließlich weitere Schichten auf die entstanden Oberfläche aufgebracht werden. Die auf der Mesastruktur wachsenden Schichten sind einkristallin, wohingegen die auf der polykristallinen Schicht gewachsenen Schichten polykristallin sind.

US 6,463,088 B1 beschreibt einen Quantenkaskadenlaser mit einer Mesastruktur. Zum Herstellen des Quantenkaskadenlasers werden zuerst epitaktische Schichten auf ein Substrat aufgebracht. Anschließend werden die Bereiche, die nicht die aktive Zone des Quantenkaskadenlasers bilden sollen, weggeätzt, so dass die Mesastruktur entsteht. Schließlich wird eine dielektrische Überzugsschicht aus einem Glasmaterial als elektrische Isolierung auf die Seitenwände der Mesastruktur und die verbleibende Substratoberfläche aufgebracht.

C.D. Farmer, et al. "A quantum cascade laser fabricated using planar nativeoxide layers", Applied Physics Letters, Volume 77, Number 1, 3 Juli 2000 beschreibt die Herstellung eines Quantenkaskadenlasers, in dem zuerst ein Schichtstapel epitaktisch auf eine Substrat aufgebracht wird und anschließend ein Teil des Materials zum Erzeugen eines elektrischen und optischen Confinements oxidiert wird.

Eine weitere Alternative für das Herstellen der Isolationszone ist das Erzeugen von Defekten mittels Protonenimplantation. Ein entsprechendes Verfahren ist bspw. in JP10229246 beschrieben. Die Protonenimplantation erfolgt nach dem Herstellen eines Schichtstapels, wobei derjenige Bereich des Schichtstapels, welcher die aktive Zone des Lasers bilden soll, maskiert wird. Da die Protonen mit hoher Energie implantiert werden, ist eine Dicke Maskierung nötig, die nicht immer ohne weiteres realisierbar ist.

Eine erste Aufgabe der vorliegenden Erfindung ist es daher, einen Quantenkaskadenlaser zur Verfügung zu stellen, welcher einerseits eine gute laterale Wärmeabfuhr aus der aktiven Zone ermöglicht und andererseits einfach herzustellen ist. Eine zweite Aufgabe der vorliegenden Erfindung ist es, ein vorteilhaftes Verfahren zum Herstellen eines derartigen Quantenkaskadenlaser zur Verfügung zu stellen.

Die erste Aufgabe wird durch einen Quantenkaskadenlaser nach Anspruch 1 gelöst, die zweite Aufgabe durch ein Verfahren zum Herstellen eines Quantenkaskadenlasers nach Anspruch 9. Die abhängigen Ansprüche enthalten vorteilhafte Ausgestaltungen der Erfindung.

Ein erfindungsgemäßer Halbleiterlaser umfasst wenigstens eine Wärme generierende aktive Zone aus einem Halbleitermaterial mit hoher kristalliner Ordnung und wenigstens eine lateral an die aktive Zone angrenzende Isolier- und Wärmeabfuhrzone aus einem elektrisch isolierenden, wärmeleitenden Material. Das elektrisch isolierende, wärmeleitende Material ist mit dem Halbleitermaterial der aktiven Zone in seinen chemischen Konstituenten bis auf etwaige Verunreinigungen identisch. Die Konstituenten können in den beiden Materialien insbesondere auch in unterschiedlichen stöchiometrischen Verhältnissen vorliegen, die sich vorteilhaft jedoch nur geringfügig (nicht mehr als 5% Abweichung) voneinander unterscheiden. Die elektrisch isolierende Eigenschaft des isolierenden, wärmeleitenden Materials beruht im erfindungsgemäßen Halbleiterlaser auf einem gegenüber dem Halbleitermaterial der aktiven Zone verringerten Grad an kristalliner Ordnung. Unter Halbleitermaterial mit hoher kristalliner Ordnung soll hierbei insbesondere einkristallines Halbleitermaterial zu verstehen sein. Dieses kann jedoch unter Umständen Kristalldefekte in geringer Konzentration aufweisen, solange die Konzentration so gering ist, dass die Funktionstüchtigkeit der aktiven Zone dadurch nicht nennenswert beeinträchtigt ist. Als Materialien mit geringer kristalliner Ordnung kommen insbesondere Materialien ohne jegliche kristalline Ordnung, also amorphe Materialien, in Betracht. Aber auch polykristalline Materialien sollen im Rahmen der Erfindung als Materialien mit einem verringerten Grad an kristalliner Ordnung anzusehen sein. Der erfindungsgemäße Halbleiterlaser ist als Quantenkaskadenlaser ausgebildet, d.h. seine aktive Zone kann eine Kaskadenstruktur, wie sie in der Einleitung beschrieben worden ist, umfassen.

Dadurch, dass das Halbleitermaterial der Isolier- und Wärmeabfuhrzone mit dem der aktiven Zone in seinen chemischen Konstituenten identisch ist, besteht zwischen beiden Zonen keine Materialgrenze. Zudem ermöglicht die Identität der Materialien beide Zonen gleichzeitig in einem einzigen Epitaxieschritt aufzubringen. Die elektrisch isolierenden Eigenschaften des Halbleitermaterials in der Wärmeabfuhrzone ergeben sich aus der hohen Anzahl von Kristalldefekten in einem Halbleitermaterial mit geringem Grad an kristalliner Ordnung. Wie hoch der Grad an kristalliner Ordnung maximal sein darf, ohne dass das Material der Isolier- und Wärmeabfuhrzone elektrisch leitend wird, hängt hierbei von seiner chemischen Zusammensetzung ab und kann für jedes Material empirisch bestimmt werden. Die Wärmeleitfähigkeit des Materials hängen dagegen nicht so sehr von der Anzahl der Kristalldefekte ab, sodass sie derjenigen des Materials mit hoher kristalliner Ordnung ähneln.

Da das Halbleitermaterial der aktiven Zone und das Halbleitermaterial der Isolier- und Wärmeabfuhrzone in ihren chemischen Konstituenten identisch sind, können sie insbesondere als eine gemeinsame Schicht oder als gemeinsamer Schichtstapel ausgebildet sein, wobei die aktive Zone von einem ersten Abschnitt der gemeinsamen Schicht bzw. des gemeinsamen Schichtstapels gebildet ist, der eine hohe kristalline Ordnung aufweist, und die Isolier- und Wärmeabfuhrzone von einem zweiten Abschnitt der gemeinsamen Schicht bzw. des gemeinsamen Schichtstapels gebildet ist, welcher die geringe kristalline Ordnung aufweist. Sowohl die aktive Zone als auch die Isolier- und Wärmeabfuhrzone können dann in einem einzigen, gemeinsamen Epitaxieschritt aufgebracht werden. Die chemische Identität der Konstituenten der aktiven Zone und der Isolier- und Wärmeabfuhrzone ermöglicht es zudem, den Halbleiterlaser mit einer planaren Struktur auszustatten.

Insbesondere kann die aktive Zone unmittelbar auf ein einkristallines Substrat, also auf einen Wafer oder eine kristallin gewachsene Schicht, und die Isolier- und Wärmeabfuhrzone unter Zwischenschaltung einer amorphen Schicht auf das einkristalline Substrat aufgebracht sein. Im Epitaxieprozess kann dann erreicht werden, dass das Halbleitermaterial in der aktiven Zone einkristallin und auf der amorphen Zwischenschicht polykristallin oder amorph aufwächst. Die amorphe Schicht braucht dabei nur eine im Verhältnis zur Dicke der aktiven Zone und der Isolier- und Wärmeabfuhrzone geringe Dicke aufzuweisen. Als amorphe Schichten eignen sich insbesondere Siliziumoxidschichten (SiOₓ-Schichten), Siliziumnitridschichten (SiNx-Schichten), Siliziumoxynitridschichten (SiₓO_{y}N_{z}-Schichten), oxidierte Indiumphosphidschichten (oxidierte InP-Schichten) oder Aluminiumoxidschichten (Al₂O₃-Schichten).

Das erfindungsgemäße Verfahren zum Herstellen eines Quantenkaskadenlasers mit wenigstens einer eine Kaskadenstruktur umfassenden aktiven Zone und einer lateral an die aktive Zone angrenzenden Isolier- und Wärmeabfuhrzone auf einem Substrat, welches ein Wafer oder eine kristallin gewachsene Schicht sein kann, umfasst die Schritte:
- Erzeugen einer amorphen Schicht auf der Substratoberfläche, also auf der Oberfläche des Wafers bzw. der kristallin gewachsenen Schicht;
- Strukturieren der Substratoberfläche durch Entfernen der amorphen Schicht von solchen Bereichen der Substratoberfläche, in denen eine aktive Zone gebildet werden soll;
beispielhaft aufgezählt sind. Andere Materialien, welche die genannten Voraussetzungen erfüllen, können ebenfalls als amorphe Schicht Verwendung finden. Nach dem Aufbringen der aktiven Zone und der Isolierund Wärmeabfuhrzone kann der Halbleiterlaser durch Abscheiden eines Schichtstapels und Aufbringen von Elektroden vollendet werden.

Da mit dem erfindungsgemäßen Verfahren die aktive Zone und die Isolierund Wärmeabfuhrzone in demselben nicht selektiven Epitaxieschritt gebildet werden, weisen sie dieselben chemischen Konstituenten auf. Aufgrund der Strukturierung der Substratoberfläche mit der amorphen Schicht erfolgt das Wachstum dort, wo sich die amorphe Schicht befindet, mit einem geringen Grad an kristallographischer Ordnung, insbesondere polykristallin oder amorph, wohingegen das Wachstum in der von der amorphen Schicht befreiten Zone mit hoher kristalliner Ordnung, insbesondere einkristallin, erfolgt. Zum Herstellen des Halbleiterlasers ist daher weder das Einstellen von Parametern eines selektiven Epitaxieprozesses, noch ein Ätzprozess nach dem Herstellen der aktiven Zone und ein nachträgliches Bilden der Isolier- und Wärmeabfuhrzone nötig. Die Komplexität des Herstellungsprozesses kann daher verringert werden. Zudem wird im erfindungsgemäßen Verfahren die aktive Zone definiert, bevor der Epitaxieprozess durchgeführt wird, sodass der Herstellungsprozess weitgehend beendet ist, wenn der Epitaxieschritt abgeschlossen ist. Die resultierende Struktur ist zudem planar, was die Kontaktierung vereinfacht. Als weiteres wichtiges Merkmal ist zu nennen, dass die Isolier- und Wärmeabfuhrzone eine hohe Wärmeleitfähigkeit und eine geringe elektrische Leitfähigkeit aufweist. Außerdem steht sie in besonders innigem Kontakt mit der aktiven Zone, da sie aus derselben epitaktischen Schicht besteht.

Gegenüber einer nachträglichen Isolierung von geätzten aktiven Zonen mit einer BCB-Beschichtung weist die Erfindung nicht nur einen höheren thermischen Leitfähigkeitskoeffizienten an den Seitenwänden der aktiven Zone auf, sondern ist auch planarer und einfacher zu bearbeiten.

Gegenüber dem aus dem Stand der Technik bekannten Implantieren von Protonen zum Herstellen einer lateral an die aktive Zone angrenzenden isolierenden Schicht kann die Isolier- und Wärmeabfuhrzone aus dem elektrisch isolierenden, wärmeleitfähigen Material dicker ausgeführt werden. Zudem ist beim Implantieren der Protonen das Eingrenzen der Implantationszone schwierig und erfordert eine aufwendige Maskierung. Weiterhin ermöglicht das im erfindungsgemäßen Halbleiterlaser zur Anwendung kommende elektrisch isolierenden, wärmeleitfähigen Material eine verbesserte Eingrenzung der optischen Mode, da ein Übergang zwischen einkristallinem und polykristallinem Material vorliegt.

Im Vergleich zu Herstellungsverfahren, in denen eine lateral an die aktive Zone angrenzende isolierende Zone nach einem Ätzschritt mittels eines zweiten Epitaxieschrittes aufgebracht wird, ist das erfindungsgemäße Verfahren um einen Verfahrensschritt reduziert.

Das Herstellen der amorphen Schicht kann auf verschiedenen Wegen erfolgen von denen einige nachfolgend Erwähnung finden.

Das Strukturieren der Substratoberfläche kann durch chemisches Entfernen der amorphen Schicht unter Verwendung eines lithographischen Prozesses, bspw. mittels eines photolithographischen Prozesses oder eines röntgenlithographischen Prozesses, mittels Elektronenstrahllithographie oder mittels Synchrotronstrahlungslithographie, erfolgen, insbesondere wenn als amorphe Schicht eine Siliziumoxid und/oder Siliziumnitrid umfassende Schicht auf das Substrat aufgebracht wird. Das Aufbringen der Siliziumoxid und/oder Siliziumnitrid umfassenden amorphen Schicht kann beispielsweise mittels Abscheidung aus der Gasphase (CVD, chemical vapor deposition) oder mittels eines Zerstäubungsverfahrens (Sputter-Verfahrens) erfolgen.

Wenn als Substrat ein III-V-Halbleitersubstrat, bspw. ein Indiumphosphidsubstrat oder ein Galliumarsenidsubstrat, Verwendung findet kann dort, wo eine aktive Zone gebildet werden soll, eine oxidationshemmende Maske aufgebracht werden. Die amorphe Schicht lässt sich dann durch Oxidieren der nicht von der Maske bedeckten Substratoberfläche erzeugen. Das Oxidieren kann beispielsweise durch Erwärmen des Substrates erfolgen. Nach der Oxidation wird die Maske dann wieder entfernt. Als Maske kommt beispielsweise eine Lackmaske in Betracht.

Wenn als amorphe Schicht eine Aluminiumoxidschicht auf dem Substrat erzeugt wird, kann dies erfolgen, indem eine Aluminiumarsenidschicht (AIAs-Schicht) auf das Substrat aufgebracht wird und eine Galliumarsenidschicht (GaAs-Schicht) auf die Aluminiumarsenidschicht aufgebracht wird. Die Galliumarsenidschicht hat die Aufgabe, die Aluminiumarsenidschicht während der nachfolgenden Strukturierung vor Oxidation zu schützen. Sie braucht daher insbesondere nur eine Dicke aufzuweisen, die genügt, um diese Schutzfunktion zu erfüllen. Hierzu genügen ca. 10 nm. Sie kann jedoch auch dicker als die Mindestdicke sein. Die Aluminiumarsenidschicht mit der aufgebrachten Galliumarsenidschicht wird dort, wo eine aktive Zone gebildet werden soll, entfernt. Danach wird die Galliumarsenidschicht von der gesamten Aluminiumarsenidschicht entfernt und die Aluminiumarsenidschicht oxidiert. Dabei kann das Entfernen der Galliumarsenidschicht entweder vor oder nach dem Oxidieren erfolgen. Wenn die Galliumarsenidschicht erst nach dem Oxidieren entfernt werden soll, so kann die Oxidation beispielsweise mittels eines feuchten Oxidationsverfahrens von der Seite der Aluminiumarsenidschicht aus erfolgen.

Als weitere Alternative zum Herstellen der amorphen Schicht besteht die Möglichkeit, die Oberfläche des Substrats mit Silizium (Si) zu beschichten und die Siliziumschicht zu oxidieren. Anschließend wird die oxidierte Siliziumschicht dort, wo die aktive Zone gebildet werden soll, entfernt.

Die genannten Beispiele für das Herstellen der amorphen Schicht zeigen, dass eine Vielzahl von Materialien und Verfahren zum Bilden der amorphen Schicht herangezogen werden können. Dies ermöglicht es, für ein Halbleitermaterial, das zum Bilden der aktiven Zone und der Isolier- und Wärmeabfuhrzone epitaktisch aufgebracht werden soll, eine geeignete amorphe Schicht herzustellen. Das erfindungsgemäße Verfahren lässt sich daher bei der Herstellung von Halbleiterlasern aus den unterschiedlichsten Materialien zur Anwendung bringen.

Weitere Merkmale, Eigenschaften und Vorteile der vorliegenden Erfindung ergeben sich aus der nachfolgenden Beschreibung von Ausführungsbeispielen unter Bezugnahme auf die beiliegenden Figuren.

Fig. 1 zeigt in einer schematischen Darstellung den Aufbau eines erfindungsgemäßen Halbleiterlasers.

Fig. 2 zeigt einen Ausschnitt aus der aktiven Schicht des in Fig. 1 gezeigten Halbleiterlasers.

Fig. 3a u. 3b zeigen ein erstes Verfahren zum Erzeugen der in Fig. 1 dargestellten amorphen Schicht.

Fig. 4a bis 4d zeigen ein zweites Verfahren zum Herstellen der in Fig. 1 gezeigten amorphen Schicht.

Fig. 5a bis 5d zeigen ein drittes Verfahren zum Herstellen der in Fig. 1 gezeigten amorphen Schicht.

Fig. 6 zeigt eine elektronenmikroskopische Aufnahme einer Indiumphosphidschicht, die auf ein Indiumphosphidsubstrat mit einer strukturierten amorphen Siliziumnitridschicht aufgebracht ist.

Figuren 7a und 7b zeigen Simulationen zum Wärmefluss in Halbleiterstrukturen.

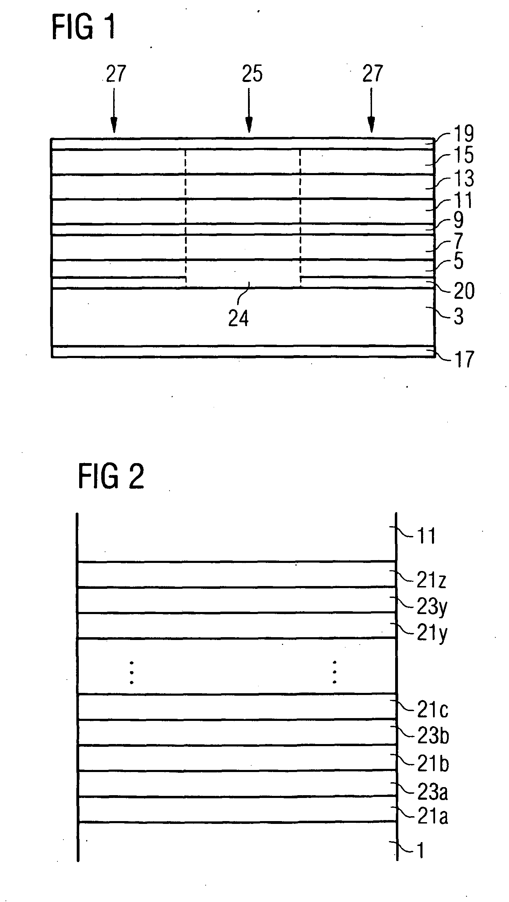

Fig. 1 zeigt ein Ausführungsbeispiel für einen Halbleiterlaser in einer Querschnittsansicht. Er ist im Wesentlichen als Schichtstapel auf einem Substrat 3 ausgeführt. Der Schichtstapel umfasst vom Substrat 3 ausgehend eine Hüllenschicht 5, eine Wellenleiterschicht 7, eine aktive Schicht 9, eine Wellenleiterschicht 11, eine Hüllenschicht 13 und eine Kontaktierungsschicht 15. Die Hüllenschichten 5, 13 weisen einen geringeren Brechungsindex als die Wellenleiterschichten 7, 11 auf, sodass die Hüllenschichten zusammen mit den Wellenleiterschichten 7, 11 und der aktiven Schicht 9 einen Wellenleiter bilden, dessen wellenleitender Kern von der aktiven Schicht 9 und den Wellenleiterschichten 7 und 11 gebildet ist. Die dem Schichtstapel abgewandte Seite des Substrats 3 ist mit einer Elektrode 17 versehen. Die dem Substrat 3 abgewandte Seite des Schichtstapels ist mit einer Elektrode 19 versehen. Zwischen der Hüllenschicht 5 und dem Substrat 3 befindet sich eine dünne amorphe Schicht 20, die das Substrat 3 außer im Bereich einer Aussparung 24 bedeckt.

Als Substrat 3 dient in der in Fig. 1 dargestellten Struktur ein Wafer. Es kann aber auch eine auf einem Wafer kristallin gewachsene Unterlage als Substrat dienen. Insbesondere kann auch die Hüllenschicht 5 das Substrat bilden, wobei der Schichtstapel dann die Hüllenschicht 5 nicht umfasst. In diesem Fall befindet sich die amorphe Schicht 20 mit der Aussparung 24 nicht wie in Fig. 1 dargestellt zwischen dem Wafer und der Hüllenschicht 5, sondern zwischen der Hüllenschicht 5 und der Wellenleiterschicht 7.

Die in Fig. 1 dargestellte Schichtstruktur eignet sich grundsätzlich sowohl zum Herstellen von Laserdioden, also von Halbleiterlasern, die auf einer Rekombination von Elektronen und Löchern an einem p-n-Übergang beruhen, als auch zum Herstellen von Quantenkaskadenlasern, die auf Intersubband-Übergängen von Elektronen innerhalb eines Leitungsbands beruhen.

In einer typischen Laserdiode sind die Elektrode 17, das Substrat 3, die Hüllenschicht 5 und die Wellenleiterschicht 7 n-dotidert, während die Hüllenschicht 13, die Wellenleiterschicht 11, die Kontaktierungsschicht 15 und die Elektrode 19 p-dotiert sind. Die Dotierungen können jedoch grundsätzlich auch umgekehrt sein, so dass also alle hier als p-dotiert aufgeführte Schichten n-dotiert sind und umgekehrt.

Die Erzeugung der Laserstrahlung findet in der aktiven Schicht 9 statt. Diese befindet sich zwischen der n-dotierten Wellenleiterschicht 7 und der p-dotierten Wellenleiterschicht 11, sodass die aktive Zone 9 als p-n-Übergang angesehen werden kann. Wenn nun eine Spannung mit einer bestimmten Mindestgröße in Durchlassrichtung des p-n-Übergangs zwischen den beiden Elektroden 17 und 19 angelegt wird, so werden in den dotierten Schichten Elektronen bzw. Löcher erzeugt. Diese diffundieren in die aktive Schicht 9, wo sie rekombinieren und dabei Photonen aussenden, die den Halbleiterlaser durch den Wellenleiter als Laserstrahlung verlässt.

Die mit Bezug auf Fig. 1 beschrieben Struktur repräsentiert im Rahmen der Erfindung einen Quantenkaskadenlaser. Im Unterschied zur Laserdiode sind in einem Quantenkaskadenlaser die Elektroden 17 und 19, das Substrat 3, die Hüllenschichten 5 und 13, die Wellenleiterschicht 7 und 11 sowie die Kontaktierungsschicht 15 einheitlich n-dotiert, wobei aber grundsätzlich auch eine einheitliche p-Dotierung möglich ist.

Die aktive Schicht 9 eines Quantenkaskadenlasers umfasst eine Vielzahl von aufeinanderfolgenden Barrierenschichten 21a bis 21z, zwischen denen jeweils eine Quantentopfschicht 23a bis 23y angeordnet ist (Fig. 2). Es sei an dieser Stelle angemerkt, dass die Bezeichnung 21a bis 21z nicht darauf hindeuten soll, dass 26 Barrierenschichten vorhanden sind, sondern lediglich zur Unterscheidung der Schichten dient. Die Zahl der Barrierenschichten kann erheblich größer sein und mehrere hundert betragen. Eine Anzahl aufeinanderfolgender Barrieren- und Quantentopfschichten können zusammen eine so genannte Kaskade bilden, wobei in einer der Quantentopfschichten einer Kaskade Elektronen aus einem hohen in ein niedriges Energieniveau unter Aussendung eines Photons übergehen. Die nachfolgende Kaskade liegt energetisch niedriger, sodass dasselbe Elektron in der nächsten Kaskade wieder einen Übergang zu einem noch niedrigeren Energieniveau durchführen kann. Auf diese Weise kann ein und dasselbe Elektron mehrmals Photonen aussenden, bis es die letzte Kaskade durchlaufen hat. Mit der in Fig. 2 dargestellten Struktur lässt sich daher ein Quantenkaskadenlaser, wie er eingangs beschrieben worden ist, realisieren.

Als eine mögliche Struktur für die aktive Schicht 9 kommt bspw. die in DE 10 2004 009 531 A1 beschriebe Quantenkaskadenstruktur in Betracht. Auf diese Druckschrift wird daher im Hinblick auf die genaue Ausgestaltung der Quantenkaskadenstruktur des Lasers verwiesen.

In dem in Fig. 1 dargestellten Halbleiterlaser finden der Stromfluss und die Erzeugung der Photonen innerhalb einer aktiven Zone 25 statt. Die aktive Zone 25, die in der Figur durch gestrichelte senkrechte Linien angedeutet ist, wird lateral zu beiden Seiten von einer Isolier- und Wärmeabfuhrzone 27 begrenzt, und durch die Aussparung 24 in der amorphen Schicht 20 definiert. Sie ist daher unmittelbar auf das Substrat 3 aufgebracht. Die Isolier- und Wärmeabfuhrzonen 27 sind dagegen unter Zwischenschaltung der amorphen Schicht 20 auf das Substrat aufgebracht. Während die aktive Zone 25 eine einkristalline Struktur aufweist, weisen die Isolier- und Wärmeabfuhrzonen 27 eine gegenüber der aktiven Zone 25 stark verminderte kristalline Ordnung auf und sind insbesondere polykristallin oder amorph ausgebildet.

Die Isolier- und Wärmeabfuhrzonen 27 dienen einerseits dazu den Stromfluss durch den Halbleiterlaser auf die aktive Zone 25 zu begrenzen und andererseits dazu, die in der aktiven Zone 25 entstehende Wärme als Abwärme abzuführen.

Die Isolier- und Wärmeabfuhrzonen 27 weisen dieselben Schichtfolgen wie die aktive Zone 25 auf. Bei der Herstellung werden sie zusammen mit den entsprechenden Schichten der aktiven Zone 25 gebildet. Mit anderen Worten, nachdem die amorphe Schicht 20 auf dem Substrat 3 erzeugt und strukturiert worden ist, werden die Schichten des Schichtstapels nacheinander in einem nicht-selektiven Epitaxieschritt auf das mittels der amorphen Schicht 20 strukturierte Substrat abgeschieden. In dem Bereich des Substrats 3, der nicht von der amorphen Schicht 20 bedeckt ist, wächst das Material einkristallin, wohingegen es auf der amorphen Schicht 20 mit geringerer kristalliner Ordnung, insbesondere polykristallin oder amorph aufwächst. Insbesondere durch eine polykristalline oder amorphe Struktur kann bei vielen Materialien einerseits erreicht werden, dass sie im Vergleich zum dem einkristallinen Material mit derselben chemischen Zusammensetzung stark elektrisch isolierende Eigenschaften aufweisen. Die Ursache hierfür liegt in der hohen Defektdichte, d.h. in der geringen kristallographischen Ordnung des polykristallinen bzw. amorphen Materials. Andererseits ist jedoch die Wärmeleitfähigkeit des Materials mit niedriger kristalliner Ordnung derjenigen des einkristallinen Materials ähnlich, sodass die Isolier- und Wärmeabfuhrzonen 27 einerseits gute elektrische Isolatoren und andererseits gute Wärmeleiter darstellen. Es kann daher die in der aktiven Zone 25 entstehende Wärme zuverlässig abgeführt werden, ohne dass auf gute elektrisch isolierende Eigenschaften der Isolier- und Wärmeabfuhrzonen 27 verzichtet werden müsste. Auch die Tatsache, dass jede Schicht aus einer einzigen Schicht mit Bereichen unterschiedlicher kristalliner Ordnung hergestellt ist, hilft die Wärmeabfuhr zu verbessern, da ein inniger Materialkontakt zwischen der aktiven Zone 25 und den Isolierund Wärmeabfuhrzonen 27 sichergestellt ist.

Der mit Bezug auf Fig. 1 beschriebene Aufbau eines Halbleiterlasers kann mit einer Vielzahl von Materialien realisiert werden. Beispielsweise bei Verwendung eines Indiumphosphid (InP)-Substrates können insbesondere im Falle eines Quantenkaskadenlasers die Hüllenschichten 5, 13 und die Kontaktierungsschicht 15 aus Indiumphosphid (InP) hergestellt sein. Die Wellenleiterschichten 7, 11 können aus Indiumgalliumarsenid (InGaAs) und die aktive Schicht 9 aus einer Vielzahl von im Wechsel angeordneten Indiumaluminiumarsenidschichten (InAIAs) und Indiumgalliumarsenidschichten (InGaAs) hergestellt sein.

Bei Verwendung eines Galliumnitridsubstrates (GaN) oder eines Saphirsubstrates können die Hüllenschichten 5, 13 beispielsweise aus einer Mischung aus Aluminiumgalliumnitrid (AIGaN) und Galliumnitrid (GaN), die Wellenleiterschichten 7, 11 aus Galliumnitrid und die aktive Schicht 9 aus Galliumnitrid oder Indiumgalliumnitrid (InGaN) hergestellt sein.

Als amorphe Schicht kommt in den beiden beschriebenen Fällen insbesondere Siliziumdioxid (SiO₂) in Betracht. Aber auch andere Materialien wie Siliziumnitrid (SiNₓ) Siliziumoxynitrid, natives Oxid von Indiumphosphid oder Aluminiumoxid können als amorphe Schicht Verwendung finden. Neben den beispielhaft aufgezählten Materialkombinationen können auch andere für das Herstellen von Halbleiterlasern gebräuchliche Materialkombinationen zum Herstellen des erfindungsgemäßen Halbleiterlasers zur Anwendung kommen.

Das Erzeugen der amorphen Schicht 20 auf dem Substrat 3 wird nachfolgend näher beschrieben.

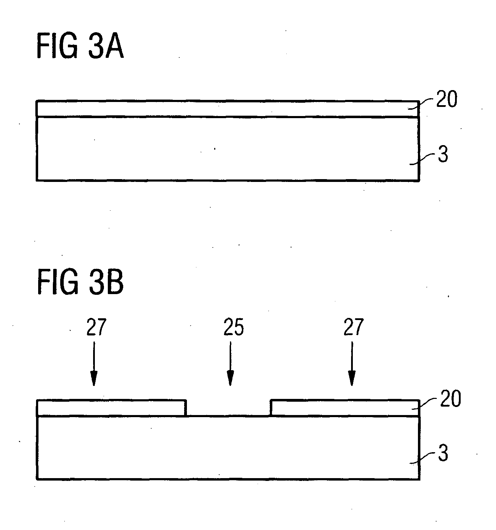

Ein erstes Ausführungsbeispiel für die Herstellung der amorphen Schicht 20 ist in den Fig. 3a und 3b gezeigt. Auf die gesamte Oberfläche des Substrates 3 wird eine Siliziumdioxid-, Siliziumoxid-, Siliziumnitrid- oder Siliziumoxynitridschicht mittels Abscheidung aus der Gasphase (CVD) oder mittels Zerstäubungsverfahren (sputtering) abgeschieden. Die abgeschiedene Schicht 20 wird anschließend unter Verwendung eines Photolithographieverfahrens aus dem Bereich 25, in dem die aktive Zone gebildet werden soll, chemisch entfernt. Für das Herstellen beispielsweise eines Quantenkaskadenlasers ist die aktive Zone ein Streifen mit einer Breite von ca. 10 bis 30 mm. Der Streifen definiert die Zone, durch die im fertigen Halbleiterlaser der Strom fließen wird - und damit auch die Zone, in der das Generieren der Photonen stattfinden wird. Außerdem beschränkt der Streifen die optische Mode des Lasers. Der Überlapp der optischen Mode mit der Zone, in der die Photonen erzeugt werden, ist ein wichtiger Faktor für das Bestimmen der Lasereffizienz. Nachdem die Oberfläche des Substrates strukturiert worden ist (Fig. 3b) erfolgt das Abscheiden des Schichtstapels wie mit Bezug auf Fig. 1 beschrieben.

Alternativ zum Abscheiden der Siliziumdioxid-, Siliziumoxid-, Siliziumnitrid- oder Siliziumoxynitridschicht kann auch Silizium auf das Substrat 3 abgeschieden werden, welches anschließend oxidiert wird. Das Strukturieren der Oberfläche erfolgt dann wiederum durch chemisches Entfernen der Siliziumdioxidschicht dort, wo die aktive Zone 25 gebildet werden soll.

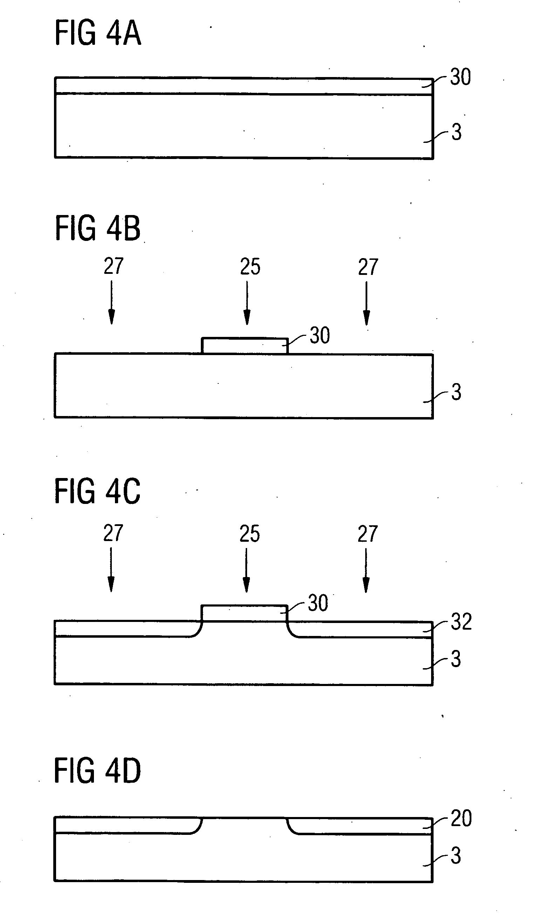

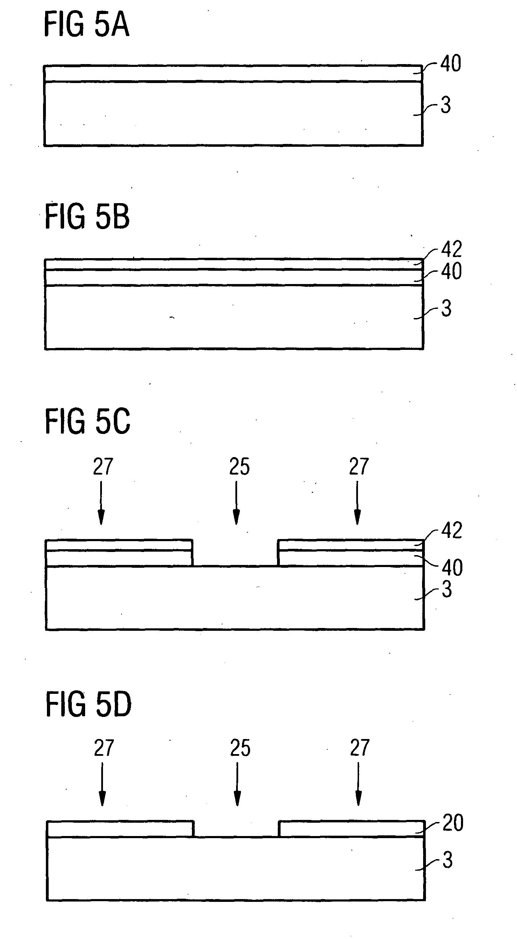

Ein alternatives Verfahren zum Herstellen der amorphen Schicht 20 ist in den Fig. 4a bis 4d gezeigt. Im zweiten Verfahren findet ein InP-Substrat Verwendung, auf das ein Photolack 30 aufgebracht wird (Fig. 5a). Mittels Photolithographie erfolgt eine Strukturierung des Photolacks 30 so, dass dieser lediglich dort verbleibt, wo die aktive Zone 25 des Halbleiterlasers gebildet werden soll. Die übrigen Zonen sind frei vom Photolack. Das InP-Substrat wird dann oxidiert, sodass sich eine Schicht aus Oxid von Indiumphosphid in den vom Photolack 30 unbedeckten Zonen 27 bildet. Das Oxid 32 des Indiumphosphids stellt dann die amorphe Schicht 20 aus Fig. 1 dar. Nach dem Herstellen des Oxids 32 wird der restliche Photolack 30 entfernt. Danach erfolgt ein Abscheiden des Schichtstapels, wie es mit Bezug auf Fig. 1 beschrieben worden ist.

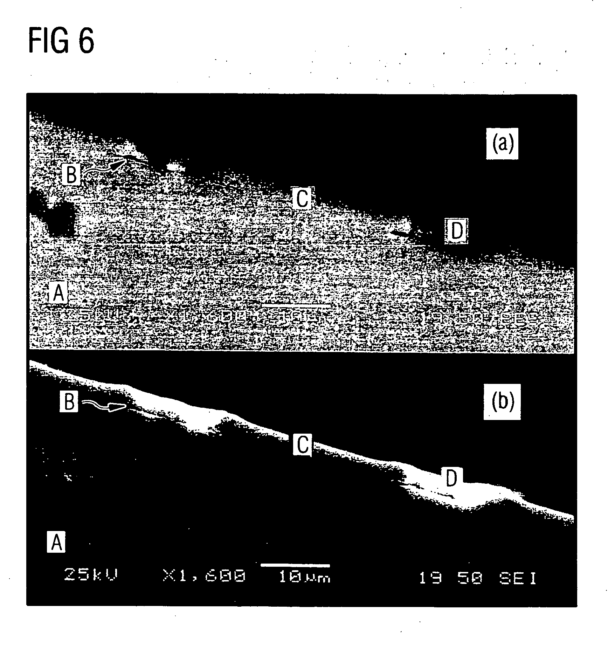

Ein drittes Verfahren zum Herstellen der amorphen Schicht 20 aus Fig. 1 ist in den Fig. 5a bis 5d dargestellt. Auch in diesem Verfahren findet wieder ein Indiumphosphidsubstrat 3 Verwendung. Es können jedoch andere Substrate, beispielsweise Galliumnitrid, zur Anwendung kommen. Auf das Substrat 3 wird, etwa mittels Molekularstrahlepitaxie (MBE, molecular beam epitaxy) eine Aluminiumarsenidschicht 40 mit einer Dicke von ca. 50 nm aufgebracht. Auf die Aluminiumarsenidschicht 40 wird eine Galliumarsenidschicht 42 mit einer Dicke von wenigstens ca. 10 nm abgeschieden (Fig. 6b). Im nächsten Schritt werden sowohl die Galliumarsenidschicht 42 als auch die Aluminiumarsenidschicht 40 dort, wo die aktive Zone 25 des Halbleiterlasers gebildet werden soll, entfernt (Fig. 6c). Anschließend wird die Galliumarsenidschicht 42 vollständig entfernt und die Aluminiumarsenidschicht 40 oxidiert, sodass sich eine Aluminiumoxidschicht bildet. Die Aluminiumoxidschicht stellt dann die amorphe Schicht 20 aus Fig. 1 dar (Fig. 5d). Danach erfolgt das Aufbringen eines Schichtstapels, wie es mit Bezug auf Fig. 1 beschrieben worden ist. Alternativ zur beschriebenen Vorgehensweise ist es auch möglich, die Galliumarsenidschicht 42 erst nach dem Oxidieren der Aluminiumarsenidschicht 40 zu entfernen. Die Oxidation der von der Galliumarsenidschicht 42 bedeckten Aluminiumarsenidschicht 40 kann dann mittels feuchter Oxidation von der Seite der Schichten aus erfolgen.

Die mit Bezug auf die Fig. 3, 4 und 5 beschriebenen Verfahren führen zu einem vorstrukturierten Substrat mit einer widerstandsfähigen amorphen Schicht 20, die eine Dicke zwischen 10 und 50 nm aufweisen kann. Wichtige Eigenschaften der amorphen Schicht 20 sind, dass sie planar ist, den hohen Temperaturen beim Wachsen des Schichtstapels und bei der weiteren Verarbeitung standhalten kann (die Temperaturen können bis zu ca. 600° C betragen), dass sie mit einem Ätzverfahren geätzt werden kann, welches das Substratmaterial nicht angreift und dass sie keine Kristallisationskeime für das einkristalline Wachstum von Halbleitermaterialien bildet. Das Abscheiden des Schichtstapels auf das vorstrukturierte Substrat kann dann mittels Molekularstrahlepitaxie oder mittels Epitaxie unter Verwendung einer gasförmigen Materialquelle erfolgen.

Wenn der in Fig. 1 dargestellte Halbleiterlaser mit dem erfindungsgemäßen Verfahren hergestellt wird, ist die aktive Zone 25 bereits vor dem Herstellen des Schichtstapels definiert, sodass der Herstellungsprozess weitgehend abgeschlossen ist, wenn der Epitaxieprozess zum Herstellen des Schichtstapels beendet ist. Die resultierende Struktur ist weitgehend planar, was die Kontaktierung durch die Elektroden 17, 19 vereinfacht.

Fig. 6 zeigt eine elektronenmikroskopische Darstellung einer Indiumphosphidschicht, die auf einem Indiumphosphidsubstrat mit einer strukturierten amorphen Siliziumnitridschicht aufgebracht worden ist. Die amorphe Siliziumnitridschicht wurde bei einer Temperatur von 350° C abgeschieden und anschließend im Bereich C mittels einer auf Wasserstofffluorid (HF) basierenden Ätzung entfernt. Das so strukturierte Substrat wurde in einen Reaktor für Epitaxie mit einer gasförmigen Quelle eingebracht, wo mit Silizium dotiertes Indiumphosphid epitaktisch bis zu einer Dicke von 2 mm aufgebracht worden ist.

In Fig. 6 zeigt der obere, schwarze Bereich Luft. Der Bereich A ist das Indiumphosphidsubstrat. Die Siliziumnitridschicht mit einer Dicke von ca. 20 nm ist im Bereich B als dünne Linie zu erkennen. Das obere Bild aus Fig. 6 ist im Rückstreumodus aufgenommen und betont die Unterschiede in der Materialstruktur. Das untere Bild aus Fig. 6 ist dagegen im Sekundärelektronenmodus aufgenommen und betont die Unterschiede in der Leitfähigkeit.

Fig. 6 zeigt, dass das Ergebnis der aufgebrachten Indiumphosphidschicht eine glatte Struktur ist, die Zonen aufweist, in denen das Indiumphosphid direkt auf dem Indiumphosphid des Substrates gewachsen ist (Zone C) und Zonen, im denen und das Indiumphosphid auf dem Siliziumnitridfilm gewachsen ist (Zone D). Das direkt auf dem Indiumphosphid des Substrates gewachsene Indiumphosphid ist n-dotiert und weist einen für den Grad an Dotierung typischen Grad an Leitfähigkeit auf. Das auf der Siliziumnitridschicht gewachsene Indiumphosphid weist dagegen einen hohen Wiederstand auf, sodass keine messbare Leitfähigkeit festgestellt werden kann.

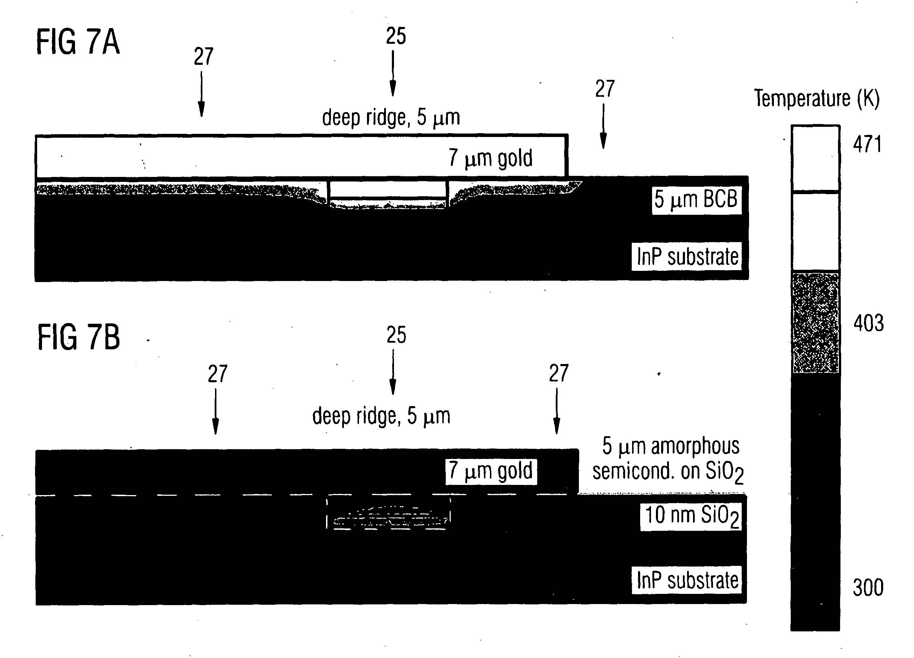

Die Figuren 7a und 7b zeigen Ergebnisse einer numerischen Simulation des stationären Wärmeflusses in Quantenkaskadenlasern mit einer Streifenbreite von 20 mm unter typischen Stromflüssen und typischen Vorspannbedingungen. Während Fig. 7a als Vergleichsergebnis das Ergebnis einer Simulation mit BCB als Isolator zeigt, zeigt Fig. 8b dieselbe Struktur, jedoch mit amorphem Halbleitermaterial, wie es mit Bezug auf Fig. 1 beschrieben worden ist, als Isolator. Es ist zu erkennen, dass die Temperatur in der aktiven Zone in Fig. 7b ca. 70°C unterhalb der Temperatur in Fig. 7a liegt, was eine signifikante Verbesserung der Wärmeabfuhr darstellt.

## Patentansprüche

1. Quantenkaskadenlaser mit wenigstens einer Wärme generierenden und eine Kaskadenstruktur umfassenden aktiven Zone (25) aus einem Halbleitermaterial mit hoher kristalliner Ordnung und wenigstens einer lateral an die aktive Zone (25) angrenzenden Isolier- und Wärmeabfuhrzone (27) aus einem elektrisch isolierenden, Wärme leitenden Material, **dadurch gekennzeichnet, dass** das elektrisch isolierende, Wärme leitende Material mit dem Halbleitermaterial der aktiven Zone (25) in seinen chemischen Konstituenten identisch ist und wobei die elektrisch isolierende Eigenschaft des isolierenden, Wärme leitenden Materials auf einem gegenüber dem Halbleitermaterial verringerten Grad an kristalliner Ordnung beruht.

2. Quantenkaskadenlaser nach Anspruch 1, in dem die Isolier- und Wärmeabfuhrzone (27) und die aktive Zone (25) von einer gemeinsamen Schicht oder einem gemeinsamen Schichtstapel gebildet sind, wobei die aktive Zone (25) von einem ersten Abschnitt der gemeinsamen Schicht bzw. des gemeinsamen Schichtstapels gebildet ist, welcher eine hohe kristalline Ordnung aufweist, und die Isolier- und Wärmeabfuhrzone (27) von einem zweiten Abschnitt der gemeinsamen Schicht bzw. des gemeinsamen Schichtstapels gebildet ist, welcher eine geringe kristalline Ordnung aufweist.

3. Quantenkaskadenlaser nach Anspruch 1 oder 2, welcher eine planare Struktur aufweist.

4. Quantenkaskadenlaser nach einem der vorangehenden Ansprüche, in dem das elektrisch isolierende, Wärme leitende Material eine polykristalline oder amorphe Struktur aufweist.

5. Quantenkaskadenlaser nach einem der vorangehenden Ansprüche, in dem die aktive Zone (25) unmittelbar auf ein Substrat (3) aufgebracht ist und die Isolier- und Wärmeabfuhrzone (27) unter Zwischenschaltung einer amorphen Schicht (20) aufgebracht ist.

6. Quantenkaskadenlaser nach Anspruch 5, in dem die amorphe Schicht (20) eine im Verhältnis zur Dicke der aktiven Zone (25) und der Isolier- und Wärmeabfuhrzone (27) geringe Dicke aufweist.

7. Quantenkaskadenlaser nach Anspruch 5 oder 6, in dem die amorphe Schicht (20) eine SiOₓ-Schicht, eine SiNₓ-Schicht, eine SiₓO_{y}N_{z}-Schicht, eine oxidierte InP-Schicht oder eine Al₂O₃-Schicht ist.

8. Quantenkaskadenlaser nach einem der vorangehenden Ansprüche, in dem die aktive Zone (25) und aus einer Vielzahl von InAlAs-Schichten und InGaAs-Schichten besteht.

9. Verfahren zum Herstellen eines Quantenkaskadenlaser mit wenigstens einer eine Kaskadenstruktur umfassenden aktiven Zone (25) und einer lateral an die aktive Zone (25) angrenzenden Isolier- und Wärmeabfuhrzone (27) auf einem Substrat (3) welches die Schritte umfasst:
- Erzeugen einer amorphen Schicht (20) auf der Substratoberfläche;
- Strukturieren der Substratoberfläche durch Entfernen der amorphen Schicht (20) von solchen Bereichen der Substratoberfläche, in denen eine aktive Zone (25) gebildet werden soll;
- gleichzeitiges Bilden der aktiven Zone (25) sowie der Isolier- und Wärmeabfuhrzone (27) durch Abscheiden von Halbleitermaterial auf die gesamte strukturierte Substratoberfläche mittels nicht selektiver Epitaxie.

10. Verfahren nach Anspruch 9, in dem als die amorphe Schicht eine SiOₓ-Schicht, eine SiNₓ-Schicht, eine SiₓO_{y}N_{z}-Schicht, eine oxidierte III-V-Halbleiterschicht oder eine Al₂O₃-Schicht erzeugt wird.

11. Verfahren nach Anspruch 9 oder 10, in dem ein chemisches Entfernen der amorphen Schicht (20) unter Verwendung eines lithographischen Prozesses erfolgt.

12. Verfahren nach Anspruch 9 oder 10, in dem als amorphe Schicht eine SiOₓ-Schicht, eine SiNₓ-Schicht oder eine SiₓO_{y}N_{z}-Schicht auf das Substrat aufgebracht wird..

13. Verfahren nach Anspruch 12, in dem das Aufbringen der SiOₓ-Schicht, der SiNₓ-Schicht bzw. der SiₓO_{y}N_{z}-Schicht mittels Abscheidung aus der Gasphase oder mittels eines Zerstäubungsverfahrens erfolgt.

14. Verfahren nach Anspruch 10, in dem als Substrat (3) ein III-V-Halbleitersubstrat Verwendung findet, auf dem dort, wo eine aktive Zone (25) gebildet werden soll, eine oxidationshemmende Maske (30) aufgebracht wird, die amorphe Schicht (20) durch Oxidieren der nicht von der Maske (30) bedeckten Substratoberfläche erzeugt wird und die Maske (30) nach dem Oxidieren wieder entfernt wird.

15. Verfahren nach Anspruch 14, in dem als Maske (30) eine Lackmaske Verwendung findet.

16. Verfahren nach Anspruch 10, in dem als amorphe Schicht (20) eine Al₂O₃-Schicht auf dem Substrat (3) erzeugt wird, indem die folgenden Schritte ausgeführt werden:
- Aufbringen einer AlAs-Schicht (40) auf das Substrat (3);
- Aufbringen einer GaAs-Schicht (42) auf die AlAs-Schicht (40);
- Entfernen der AlAs-Schicht (40) mit der aufgebrachten der GaAs-Schicht (42) dort, wo eine aktive Zone (25) gebildet werden soll;
- Entfernen der GaAs-Schicht (42) von der AlAs-Schicht (40) und Bilden der Al₂O₃-Schicht durch Oxidation der AlAs-Schicht (40).

17. Verfahren nach Anspruch 16, in dem das Entfernen der GaAs-Schicht (42) von der AlAs-Schicht (40) nach der Oxidation der AlAs-Schicht (40) erfolgt.

18. Verfahren nach Anspruch 16, in dem das Oxidieren der AlAs-Schicht nach dem Entfernen der GaAs-Schicht (42) von der AlAs-Schicht (40) erfolgt.

19. Verfahren nach Anspruch 10, in dem als amorphe Schicht (20) eine Siliziumoxidschicht gebildet wird, indem die Oberfläche des Substrats mit Si beschichtet und die Si-Schicht oxidiert wird und anschließend ein Entfernen der oxidierten Si-Schicht dort erfolgt, wo die aktive Zone (25) gebildet werden soll.

## Claims

1. Quantum cascade laser comprising at least one active zone (25) which generates heat and comprises a cascade structure, said active zone being made from a semiconductor material with high crystalline order, and at least one insulating and heat-dissipating zone (27) which laterally adjoins the active zone (25) and is made from an electrically insulating, heat-conducting material, **characterised in that** the electrically insulating, heat-conducting material is identical to the semiconductor material of the active zone (25) in terms of its chemical constituents, and wherein the electrically insulating property of the insulating, heat-conducting material is based on a reduced level of crystalline order compared to the semiconductor material.

2. Quantum cascade laser according to claim 1, in which the insulating and heat-dissipating zone (27) and the active zone (25) are formed from a common layer or from a common layer stack, wherein the active zone (25) is formed from a first portion of the common layer or of the common layer stack which has a high crystalline order, and the insulating and heat-dissipating zone (27) is formed from a second portion of the common layer or of the common layer stack which has a low crystalline order.

3. Quantum cascade laser according to claim 1 or 2, which has a planar structure.

4. Quantum cascade laser according to one of the preceding claims, in which the electrically insulating, heat-conducting material has a polycrystalline or amorphous structure.

5. Quantum cascade laser according to one of the preceding claims, in which the active zone (25) is applied directly to a substrate (3), and the insulating and heat-dissipating zone (27) is applied with the interposition of an amorphous layer (20).

6. Quantum cascade laser according to claim 5, in which the amorphous layer (20) has a small thickness compared to the thickness of the active zone (25) and of the insulating and heat-dissipating zone (27).

7. Quantum cascade laser according to claim 5 or 6, in which the amorphous layer (20) is an SiOₓ layer, an SiNₓ layer, an SiₓO_{y}N_{z} layer, an oxidised InP layer or an Al₂O₃ layer.

8. Quantum cascade laser according to one of the preceding claims, in which the active zone (25) consists of a plurality of InAlAs layers and InGaAs layers.

9. Method for producing a quantum cascade laser comprising, on a substrate (3), at least one active zone (25) which comprises a cascade structure, and an insulating and heat-dissipating zone (27) which laterally adjoins the active zone (25), which method comprises the steps of:
- producing an amorphous layer (20) on the substrate surface;
- structuring the substrate surface by removing the amorphous layer (20) from those areas of the substrate surface in which an active zone (25) is to be formed;
- simultaneously forming the active zone (25) and the insulating and heat-dissipating zone (27) by depositing semiconductor material on the entire structured substrate surface by means of non-selective epitaxy.

10. Method according to claim 9, in which an SiOₓ layer, an SiNₓ layer, an SiₓO_{y}N_{z} layer, an oxidised III-V-semiconductor layer or an Al₂O₃ layer is produced as the amorphous layer.

11. Method according to claim 9 or 10, in which a chemical removal of the amorphous layer (20) takes place using a lithographic process.

12. Method according to claim 9 or 10, in which an SiOₓ layer, an SiNₓ layer or an SiₓO_{y}N_{z} layer is applied as the amorphous layer to the substrate.

13. Method according to claim 12, in which the application of the SiOₓ layer, of the SiNₓ layer or of the SiₓO_{y}N_{z} layer takes place by means of gas phase deposition or by means of a spraying method.

14. Method according to claim 10, in which the substrate (3) used is a III-V-semiconductor substrate on which an oxidation-inhibiting mask (30) is applied in the area where an active zone (25) is to be formed, the amorphous layer (20) is produced by oxidising the substrate surface not covered by the mask (30), and the mask (30) is removed again following the oxidation.

15. Method according to claim 14, in which a resist mask is used as the mask (30).

16. Method according to claim 10, in which an Al₂O₃ layer is produced as the amorphous layer (20) on the substrate (3) by carrying out the following steps:
- applying an AlAs layer (40) to the substrate (3);
- applying a GaAs layer (42) to the AlAs layer (40);
- removing the AlAs layer (40) with the applied GaAs layer (42) in the area where an active zone (25) is to be formed;
- removing the GaAs layer (42) from the AlAs layer (40) and forming the Al₂O₃ layer by oxidising the AlAs layer (40).

17. Method according to claim 16, in which the removal of the GaAs layer (42) from the AlAs layer (40) takes place following the oxidation of the AlAs layer (40).

18. Method according to claim 16, in which the oxidation of the AlAs layer takes place following the removal of the GaAs layer (42) from the AlAs layer (40).

19. Method according to claim 10, in which a silicon oxide layer is formed as the amorphous layer (20) in that the surface of the substrate is coated with Si and the Si layer is oxidised and then a removal of the oxidised Si layer takes place in the area where the active zone (25) is to be formed.

## Revendications

1. Laser à cascades quantiques comportant au moins une zone active (25) générant de la chaleur et comprenant une structure en cascades, réalisée dans un matériau semi-conducteur d'ordre cristallin élevé, et au moins une zone d'isolation et de dissipation de chaleur (27) adjacente latéralement à la zone active (25), réalisée dans un matériau thermoconducteur électriquement isolant, **caractérisé en ce que** le matériau thermoconducteur électriquement isolant est identique dans ses constituants chimiques au matériau semi-conducteur de la zone active (25) et **en ce que** la propriété électriquement isolante du matériau thermoconducteur électriquement isolant repose sur un degré d'ordre cristallin réduit par rapport au matériau semi-conducteur.

2. Laser à cascades quantiques selon la revendication 1, dans lequel la zone d'isolation et de dissipation de chaleur (27) et la zone active (25) sont formées d'une couche commune ou d'un empilement de couches commun, la zone active (25) étant constituée d'une première section de la couche commune ou de l'empilement de couches commun qui présente un ordre cristallin élevé, et la zone d'isolation et de dissipation de chaleur (27) étant constituée d'une deuxième section de la couche commune ou de l'empilement de couches commun qui présente un ordre cristallin faible.

3. Laser à cascades quantiques selon la revendication 1 ou 2, qui présente une structure planaire.

4. Laser à cascades quantiques selon l'une des revendications précédentes, dans lequel le matériau thermoconducteur électriquement isolant présente une structure polycristalline ou amorphe.

5. Laser à cascades quantiques selon l'une des revendications précédentes, dans lequel la zone active (25) est déposée directement sur un substrat (3) et la zone d'isolation et de dissipation de chaleur (27) est déposée en intercalant une couche amorphe (20).

6. Laser à cascades quantiques selon la revendication 5, dans lequel la couche amorphe (20) présente une épaisseur faible par rapport à l'épaisseur de la zone active (25) et de la zone d'isolation et de dissipation de chaleur (27).

7. Laser à cascades quantiques selon la revendication 5 ou 6, dans lequel la couche amorphe (20) est une couche de SiOₓ, une couche de SiNₓ, une couche de SiₓO_{y}N_{z}, une couche de InP oxydée ou une couche de Al₂O₃.

8. Laser à cascades quantiques selon l'une des revendications précédentes, dans lequel la zone active (25) est constituée d'une pluralité de couches InAlAs et de couches InGaAs.

9. Procédé de fabrication d'un laser à cascades quantiques comportant au moins une zone active (25) comprenant une structure en cascades et une zone d'isolation et de dissipation de chaleur (27) adjacente latéralement à la zone active (25) sur un substrat (3), comprenant les étapes suivantes :
- production d'une couche amorphe (20) sur la surface du substrat ;
- structuration de la surface du substrat par élimination de la couche amorphe (20) de régions de la surface du substrat dans lesquelles doit être formée une zone active (25) ;
- formation simultanée de la zone active (25) ainsi que de la zone d'isolation et de dissipation de chaleur (27) par dépôt de matériau semi-conducteur sur toute la surface structurée du substrat par épitaxie non sélective.

10. Procédé selon la revendication 9, dans lequel est produite, en tant que couche amorphe, une couche de SiOₓ, une couche de SiNₓ, une couche de SiₓO_{y}N_{z}, une couche semi-conductrice III-V oxydée ou une couche de Al₂O₃.

11. Procédé selon la revendication 9 ou 10, dans lequel s'opère une élimination chimique de la couche amorphe (20) par utilisation d'un procédé lithographique.

12. Procédé selon la revendication 9 ou 10, dans lequel est déposée en tant que couche amorphe sur le substrat une couche de SiOₓ, une couche de SiNₓ ou une couche de SiₓO_{y}N_{z}.

13. Procédé selon la revendication 12, dans lequel le dépôt de la couche de SiOₓ, de la couche de SiNₓ ou de la couche de SiₓO_{y}N_{z} est réalisé par dépôt en phase vapeur ou au moyen d'un procédé d'atomisation.

14. Procédé selon la revendication 10, dans lequel est utilisé comme substrat (3) un substrat semi-conducteur III-V sur lequel, là où doit être formée une zone active (25), un masque antioxydant (30) est appliqué, la couche amorphe (20) est produite par oxydation de la surface du substrat non couverte par le masque (30) et le masque (30) est de nouveau éliminé après l'oxydation.

15. Procédé selon la revendication 14, dans lequel est utilisé comme masque (30) un masque de vernis.

16. Procédé selon la revendication 10, dans lequel une couche d'Al₂O₃ est produite sur le substrat (3) en tant que couche amorphe (20) en exécutant les étapes suivantes :
- dépôt d'une couche d'AlAs (40) sur le substrat (3) ;
- dépôt d'une couche de GaAs (42) sur la couche d'AlAs (40) ;
- élimination de la couche d'AlAs (40) avec la couche de GaAs (42) déposée, à l'endroit où une zone active (25) doit être formée ;
- élimination de la couche de GaAs (42) de la couche d'AlAs (40) et formation de la couche d'Al₂O₃ par oxydation de la couche d'AlAs (40).

17. Procédé selon la revendication 16, dans lequel l'élimination de la couche de GaAs (42) de la couche d'AlAs (40) a lieu après oxydation de la couche d'AlAs (40).

18. Procédé selon la revendication 16, dans lequel l'oxydation de la couche d'AlAs a lieu après élimination de la couche de GaAs (42) de la couche d'AlAs (40).

19. Procédé selon la revendication 10, dans lequel une couche d'oxyde de silicium est formée en tant que couche amorphe (20) en revêtant la surface du substrat de Si et en oxydant la couche de Si, une élimination de la couche de Si oxydée ayant lieu ensuite à l'endroit où doit être formée la zone active (25).
